# EUROPEAN PATENT APPLICATION

(11) **EP 3 461 787 A1**
(43) Date of publication of application: **03.04.2019**
(21) Application number: 17818849.6
(22) Date of filing: 03.03.2017
(51) Int. Cl.: B81B 7/02

(54) **MICROMIRROR UNIT AND MANUFACTURING METHOD, MICROMIRROR ARRAY, AND OPTICAL CROSS-CONNECT MODULE**

(30) Priority: 28.06.2016 CN 201610495464
(71) Applicant: Huawei Technologies Co., Ltd., Longgang District Shenzhen, Guangdong 518129 (CN)
(72) Inventor: YAO, Danyang, Shenzhen Guangdong 518129 (CN); JIANG, Chendi, Shenzhen Guangdong 518129 (CN); ZHANG, Peng, Shenzhen Guangdong 518129 (CN)
(74) Representative: Gill Jennings & Every LLP
(86) International application number: PCT/CN2017/075614
(87) International publication number: WO 2018/000850

(57) **Abstract**

A micromirror unit (200), comprising a mirror (210) and a drive apparatus (220). A side of the mirror (210) facing the drive apparatus (220) is provided with a support post(211). The drive apparatus (220) comprises a supporting frame (221), an rotation block (222) fixedly connected to the supporting post (211), and a plurality of piezoelectric drive arms (223) provided along a peripheral edge of the rotation block (222). An end of each of the piezoelectric drive arms is fixed on the supporting frame (221), and another end thereof is connected to the rotation block (222) via an elastic member (224) provided between the other end and the rotation block. The piezoelectric drive arm (223) comprises an upper electrode, a lower electrode, and a piezoelectric material clamped between the upper electrode and the lower electrode. Further disclosed are a micromirror array (2) comprising a plurality of the micromirror units (200) arranged in an array; and an optical cross-connect module comprising the micromirror array (2).

## Description

This application claims priority to Chinese Patent Application No. 201610495464.3, filed with the Chinese Patent Office on June 28, 2016 and entitled "MICROMIRROR UNIT AND FABRICATION METHOD OF SAME, MICROMIRROR ARRAY, AND OPTICAL CROSS-CONNECT MODULE", which is incorporated herein by reference in its entirety.

### TECHNICAL FIELD

This application relates to the field of communications technologies, and in particular, to a micromirror unit and a fabrication method of same, a micromirror array, and an optical cross-connect module.

### BACKGROUND

Modern communications technologies, especially high-speed mobile Internet, cloud computing, and big data technologies, have been developing in recent years. Therefore, in daily life, people can conveniently and smoothly access the Internet at any time and any place to do shopping, watch high-definition videos, query data, and so on. Inevitably, massive communications data needs to be processed to provide such new Internet experience. When existing communications devices handle such massive information transmission and exchange services, congestion and delay occur from time to time, affecting user experience.

An optical cross-connect (Optical Cross-Connect, OXC) module built by using a micro-electro-mechanical systems (Micro-Electro-Mechanical System, MEMS) micromirror array can facilitate optical transmission and optical switching without optical-to-electrical conversion in a communications system, so that capacity and a rate of information transmission can be ensured. An optical cross-connect module based on a micromirror array has advantages such as a low loss, low crosstalk, low polarization sensitivity, and a high extinction ratio, and is therefore widely applied to a backbone network or medium and large scale data centers. Therefore, high-speed information transmission on an all-optical path is implemented, thereby providing strong support for massive information exchange services in future.

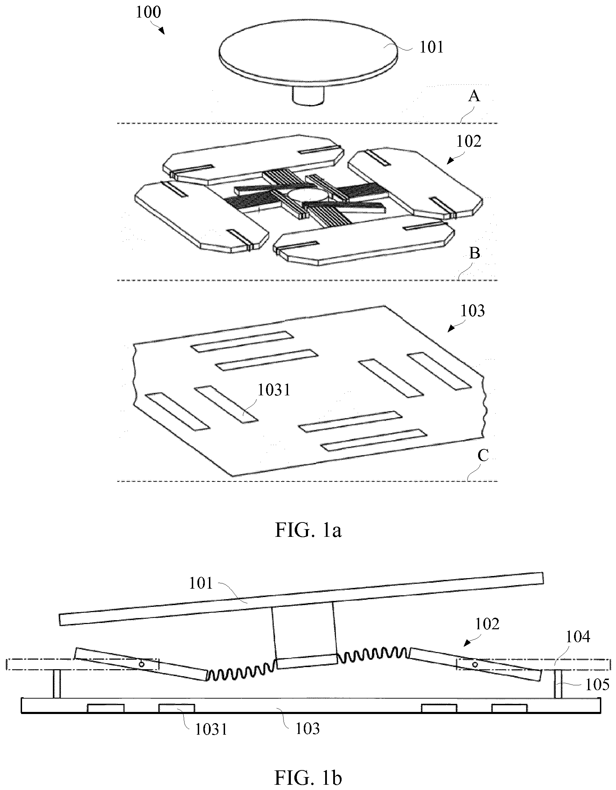

In the prior art, in a micromirror unit 100 of an electrostatically driven micromirror array shown by a structure in FIG. 1a and FIG. 1b, the micromirror unit 100 includes a mirror 101, an electrostatic drive apparatus 102, and an electrode part 103. The mirror 101 and the electrostatic drive apparatus 102 are separately placed on different planes A and B. A support post of the mirror 101 is connected by bonding to a rotation block of the electrostatic drive apparatus 102. The electrostatic drive apparatus 102 is hinged to a frame 104, so that the electrostatic drive apparatus 102 can move when driven by electrostatic attraction of the electrode part 103. The electrode part 103 is placed on a third plane C. A support 105 of the frame 104 is connected by bonding to the electrode part 103 provided with an electrode 1031. Therefore, the existing micromirror unit 100 uses the electrostatic drive apparatus 102 and has a three-layer structure. Two bonding connections are needed during a fabrication process. As a result, the micromirror unit 100 has a complex structure and is difficult to fabricate.

### SUMMARY

Embodiments of this application provide a micromirror unit and a fabrication method of same, a micromirror array, and an optical cross-connect module. The micromirror array includes a plurality of micromirror units distributed in an array. The optical cross-connect module includes a micromirror array. The micromirror unit is easy to fabricate and has a simple structure, a fast switching speed, and a high mirror fill factor.

According to a first aspect, an embodiment of this application provides a micromirror unit, including a mirror and a drive apparatus, where a support post is disposed on a side, facing the drive apparatus, of the mirror; the drive apparatus includes a support frame, a rotation block fastened to the support post, and a plurality of piezoelectric drive arms disposed surrounding the rotation block; and an end of each piezoelectric drive arm is fastened to the support frame, the other end is connected to the rotation block by using an elastic member, and the piezoelectric drive arm includes an upper electrode, a lower electrode, and a piezoelectric material sandwiched between the upper electrode and the lower electrode.

With reference to the first aspect, in a first possible implementation, the support frame is a support frame fabricated by using a silicon material; and/or
the support post is a support post fabricated by using a silicon material; and/or
the elastic member is an elastic member fabricated by using a silicon material; and/or
the rotation block is a rotation block fabricated by using a silicon material.

A silicon material has characteristics of stable chemical properties, a desirable thermal conduction effect, desirable reliability, and a long service life. Therefore, when the support frame, the support post, the elastic member, and the rotation block are fabricated by using a silicon material, the micromirror unit has characteristics of a desirable heat dissipation effect, a long service life, and desirable reliability.

With reference to the first aspect, in a second possible implementation, the elastic member is at least one spring.

With reference to the first aspect, in a third possible implementation, the plurality of piezoelectric drive arms in the drive apparatus are evenly distributed in a circumferential direction of the rotation block.

The plurality of piezoelectric drive arms in the drive apparatus are evenly distributed in the circumferential direction of the rotation block. An end of the piezoelectric drive arm is connected to the rotation block by using the elastic member. Therefore, the plurality of piezoelectric drive arms in the drive apparatus form a radial radiation shape centered at the rotation block. The plurality of evenly distributed piezoelectric drive arms can improve accuracy and stability of movement in the drive apparatus.

With reference to the third possible implementation of the first aspect, in a fourth possible implementation, the drive apparatus includes a first piezoelectric drive arm, a second piezoelectric drive arm, a third piezoelectric drive arm, and a fourth piezoelectric drive arm whose extending directions pass through a center of the rotation block, where the extending direction of the first piezoelectric drive arm is parallel to the extending direction of the second piezoelectric drive arm, the extending direction of the third piezoelectric drive arm is parallel to the extending direction of the fourth piezoelectric drive arm, and the extending direction of the third piezoelectric drive arm is perpendicular to the extending direction of the first piezoelectric drive arm.

With reference to the third possible implementation of the first aspect, in a fifth possible implementation, the drive apparatus includes a fifth piezoelectric drive arm, a sixth piezoelectric drive arm, and a seventh piezoelectric drive arm whose extending directions pass through a center of the rotation block, where an included angle between the extending direction of the fifth piezoelectric drive arm and the extending direction of the sixth piezoelectric drive arm is 120°, an included angle between the extending direction of the fifth piezoelectric drive arm and the extending direction of the seventh piezoelectric drive arm is 120°, and an included angle between the extending direction of the sixth piezoelectric drive arm and the extending direction of the seventh piezoelectric drive arm is 120°.

With reference to any one of the first aspect, the first possible implementation, the second possible implementation, the third possible implementation, the fourth possible implementation, or the fifth possible implementation, in a sixth possible implementation, the mirror is a circular mirror, or the mirror is a square mirror.

According to a second aspect, an embodiment of this application provides a micromirror array, including a plurality of the micromirror units according to any one of the foregoing seven possible implementations, and the plurality of the micromirror units are distributed in an array.

According to a third aspect, an embodiment of this application provides an optical cross-connect module, including the micromirror array according to a possible implementation of the second aspect.

When the micromirror array uses the foregoing micromirror units for array distribution, because the micromirror unit has a high mirror fill factor, more micromirror units can be integrated in a unit area, so that an integration degree of the micromirror array is increased. When a quantity of micromirror units is unchanged, a volume of the micromirror array can be reduced.

According to a fourth aspect, an embodiment of this application provides a fabrication method of the micromirror unit according to any one of the foregoing seven possible implementations of the first aspect, including:
forming a mirror structure and a drive structure, where the mirror structure includes a mirror and a support post located on a side of the mirror; the drive structure includes a substrate and a plurality of piezoelectric drive arms formed on a side, facing the mirror, of the substrate; the substrate includes a bottom plate, a first dioxide silicon layer, and a monocrystalline silicon layer, and the monocrystalline silicon layer is configured to form a rotation block and an elastic member; and the plurality of piezoelectric drive arms are disposed surrounding the rotation block, an end of each piezoelectric drive arm is connected to the rotation block by using the elastic member, and the piezoelectric drive arm includes an upper electrode, a lower electrode, and a piezoelectric material sandwiched between the upper electrode and the lower electrode;
fastening the support post to the rotation block in a bonding manner; and
etching the bottom plate of the drive structure to form a support frame, and removing a portion that is of the first dioxide silicon layer and that corresponds to at least a part of each of the elastic member, the rotation block, and each piezoelectric drive arm to form a drive apparatus.

With reference to the fourth aspect, in a first possible implementation, in the step of forming the drive apparatus:
before the fastening the support post to the rotation block in a bonding manner, the fabrication method includes:
   sequentially depositing a second dioxide silicon layer, the lower electrode, a piezoelectric material layer, and the upper electrode on a side, opposite to the bottom plate, of the monocrystalline silicon layer of the substrate;
   etching the upper electrode, the piezoelectric material layer, the lower electrode, and the second dioxide silicon layer, to form the plurality of piezoelectric drive arms; and
   etching the monocrystalline silicon layer, to form the elastic member and the rotation block; and
after the fastening the support post to the rotation block in a bonding manner, the fabrication method includes:
   removing the portion that is of the first dioxide silicon layer and that corresponds to at least a part of each of the elastic member, the rotation block, and each piezoelectric drive arm.

With reference to the fourth aspect, in a second possible implementation, the step of forming a mirror structure includes:
etching a monocrystalline silicon layer of a substrate, to form the support post.

With reference to any one of the fourth aspect, the first possible implementation, or the second possible implementation, in a third possible implementation, in the fastening the support post to the rotation block in a bonding manner, the bonding is low temperature bonding.

The support post and the rotation block are bonded at low temperature. Therefore, quality and strength of bonding between the support post and the rotation block can be improved.

In the embodiments of this application, according to the micromirror unit provided in the first aspect, the micromirror array provided in the second aspect, the optical cross-connect module provided in the third aspect, and the fabrication method of the micromirror unit provided in the fourth aspect, the micromirror unit includes the mirror and the drive apparatus. The drive apparatus uses the piezoelectric drive arms to drive the mirror to rotate. The mirror of the micromirror unit is fastened to the rotation block of the drive apparatus by using the support post. In the drive apparatus, an electrode does not need to be separately disposed on another plane. In addition, the support post of the mirror and the rotation block of the drive apparatus are located on different planes. Therefore, the mirror and the drive apparatus are separable and do not affect each other, so that a mirror fill factor (a percentage of an area of the mirror in an area of the entire micromirror unit) can be increased and can reach 80% or higher. In comparison with electrostatic driving in the prior art, drive force of piezoelectric driving used in the micromirror unit is two to three orders of magnitude greater than drive force of electrostatic driving. Therefore, when the piezoelectric drive arms are configured to drive the mirror to be switched from one deflection angle to another deflection angle, a switching speed is fast. In addition, the mirror and the drive apparatus only require the support post and the rotation block to be fastened. Therefore, only one time of fastening is needed, and the micromirror unit has a simple structure and is easy to fabricate.

Therefore, the micromirror unit is easy to fabricate and has a simple structure, a fast switching speed, and a high mirror fill factor.

### BRIEF DESCRIPTION OF DRAWINGS

FIG. 1a and FIG. 1b are schematic structural diagrams of a micromirror unit in the prior art;
FIG. 2 is a schematic structural diagram of a micromirror unit according to an embodiment of this application;
FIG. 3 is a schematic structural diagram of a mirror of the micromirror unit in FIG. 2;
FIG. 4 is a partially enlarged schematic diagram of a drive apparatus of the micromirror unit in FIG. 2;
FIG. 5 is a schematic structural diagram of another micromirror unit according to an embodiment of this application;
FIG. 6 is a schematic structural diagram of another micromirror unit according to an embodiment of this application;
FIG. 7a to FIG. 7e are schematic structural diagrams of a drive apparatus according to an embodiment of this application;
FIG. 8a is a schematic structural diagram of a micromirror array according to an embodiment of this application;
FIG. 8b is a schematic structural diagram of another micromirror array according to an embodiment of this application;
FIG. 9 is a process flowchart of a fabrication method of a micromirror unit according to an embodiment of this application;
FIG. 10 is a process flowchart of forming a drive apparatus in the fabrication method in FIG. 9;
FIG. 11 is a process flowchart of forming a mirror structure in the fabrication method in FIG. 9;
FIG. 12a to FIG. 12d are structural change diagrams of a drive structure corresponding to the process flowchart in FIG. 10;
FIG. 13a and FIG. 13b are structural change diagrams of the mirror structure corresponding to the process flowchart in FIG. 11;
FIG. 14 is a structural change diagram corresponding to a second step in FIG. 9; and
FIG. 15a and FIG. 15b are structural change diagrams corresponding to a third step in FIG. 9.

### DESCRIPTION OF EMBODIMENTS

The following further describes the embodiments of this application in detail with reference to the accompanying drawings.

Embodiments of this application provide a micromirror unit and a fabrication method of same, a micromirror array, and an optical cross-connect module. The micromirror array includes a plurality of micromirror units distributed in an array. The optical cross-connect module includes a micromirror array. The micromirror unit is easy to fabricate and has a simple structure, a fast switching speed, and a high mirror fill factor.

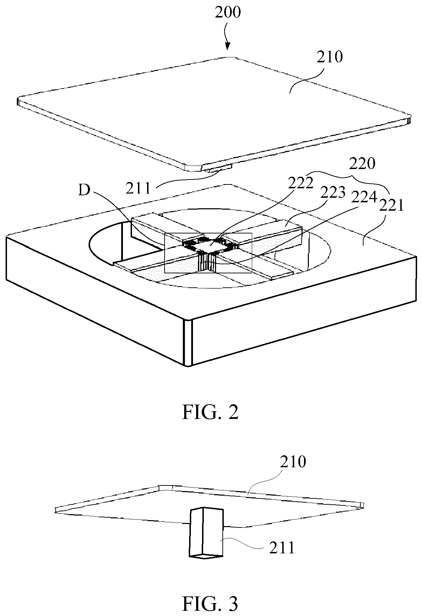

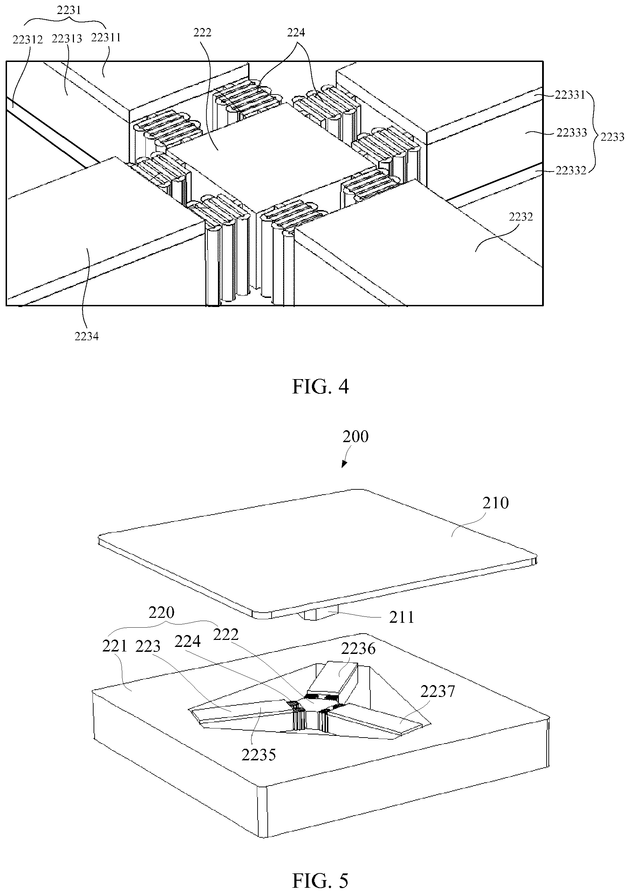

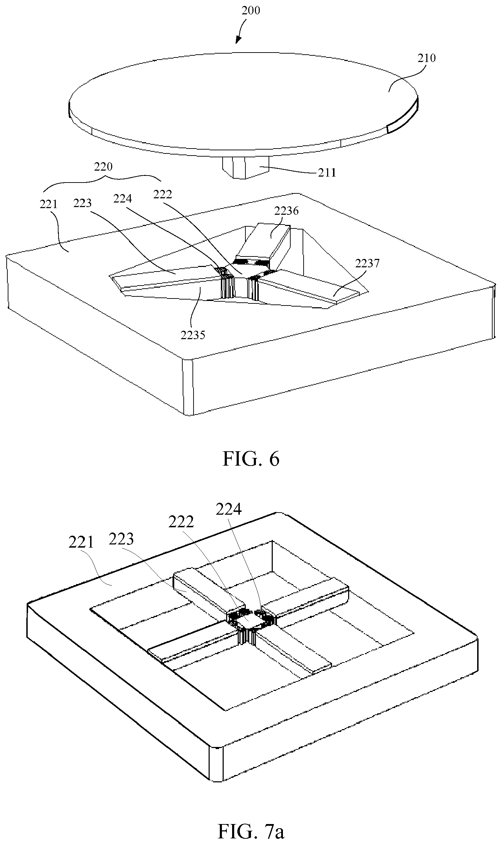

Refer to FIG. 2, FIG. 3, and FIG. 4. FIG. 4 is a partially enlarged view of a part D in FIG. 2. A micromirror unit 200 provided in an embodiment of this application includes a mirror 210 and a drive apparatus 220. As shown in a structure in FIG. 3, a support post 211 is disposed on a side, facing the drive apparatus 220, of the mirror 210. The drive apparatus 220 includes a support frame 221, a rotation block 222 fastened to the support post 211, and a plurality of piezoelectric drive arms 223 disposed surrounding the rotation block 222. The drive apparatus 220 shown in the structure in FIG. 3 and FIG. 4 includes four piezoelectric drive arms. The drive apparatus 220 shown in the structure in FIG. 5 and FIG. 6 includes three piezoelectric drive arms. An end of each piezoelectric drive arm 223 is fastened to the support frame 221. The other end is connected to the rotation block 222 by using an elastic member 224. Each piezoelectric drive arm 223 includes an upper electrode, a lower electrode, and a piezoelectric material sandwiched between the upper electrode and the lower electrode. As shown in a structure in FIG. 4, a piezoelectric drive arm 2231 includes an upper electrode 22311, a lower electrode 22312, and a piezoelectric material 22313 sandwiched between the upper electrode 22311 and the lower electrode 22312, and a piezoelectric drive arm 2233 includes an upper electrode 22331, a lower electrode 22332, and a piezoelectric material 22333 sandwiched between the upper electrode 22331 and the lower electrode 22332.

In a specific working process, the micromirror unit 200 applies voltages to the upper electrodes and the lower electrodes of the piezoelectric drive arms 223. The piezoelectric materials are driven, to move, by the voltages applied to the upper electrode and the lower electrode. The piezoelectric drive arms 223 use the elastic member 224 to drive the rotation block 222 to move. As shown in the structure in FIG. 4, a forward voltage is applied to the upper electrode 22311 and the lower electrode 22312 of the piezoelectric drive arm 2231. The piezoelectric drive arm 2231 is driven by the piezoelectric material 22313 to use the elastic member 224 to drive a side of the rotation block to move upward. Meanwhile, a reverse voltage is applied to an upper electrode and a lower electrode of a piezoelectric drive arm 2232. The piezoelectric drive arm 2232 is driven by a piezoelectric material of the piezoelectric drive arm 2232 to use the elastic member 224 to drive a side of the rotation block to move downward. In this case, when different voltages are applied to the piezoelectric drive arm 2231 and the piezoelectric drive arm 2232, the rotation block 222 can rotate about an axial line intersecting with and perpendicular to an extending direction of the piezoelectric drive arm 2231. Similarly, the rotation block 222 can rotate about an axial line intersecting with and perpendicular to an extending direction of the piezoelectric drive arm 2233. Therefore, the mirror 210 rotates through the fastening between the rotation block 222 and the support post 211, to adjust a deflection angle of the mirror 210. The rotation block 222 can achieve different movements by using different voltages applied to the plurality of piezoelectric drive arms 223. The support post 211 of the mirror 210 is fastened to the rotation block 222, so that the rotation block 222 drives the mirror 210 to move, and the piezoelectric drive arms 223 drives the mirror 210 to adjust the deflection angle of the mirror 210.

The drive apparatus 220 of the micromirror unit 200 uses the piezoelectric drive arms 223 to drive the mirror 210. The mirror 210 of the micromirror unit 200 is fastened to the rotation block 222 of the drive apparatus 220 by using the support post 211. In the drive apparatus 220, an electrode does not need to be separately disposed on another plane. Therefore, the mirror 210 and the drive apparatus 220 only need to be disposed on two planes. In addition, the support post 211 of the mirror 210 and the rotation block 222 of the drive apparatus 220 are located on different planes. Therefore, the mirror 210 and the drive apparatus 220 are separable and do not affect each other, so that a mirror fill factor (a percentage of an area of the mirror 210 in an area of the entire micromirror unit 200) can be increased and can reach 80% or higher. The drive apparatus 220 uses the piezoelectric drive arms 223 to drive the mirror 210. In comparison with electrostatic driving in the prior art, drive force of piezoelectric driving used in the micromirror unit 200 is two to three orders of magnitude greater than drive force of electrostatic driving. Therefore, when the piezoelectric drive arms 223 are configured to drive the mirror 210 to be switched from one deflection angle to another deflection angle, a switching speed is fast. In addition, the mirror 210 and the drive apparatus 220 only require the support post 211 and the rotation block 222 to be fastened. Therefore, only one time of fastening is needed, and the micromirror unit has a simple structure and is easy to fabricate.

Therefore, the micromirror unit 200 is easy to fabricate and has a simple structure, a fast switching speed, and a high mirror fill factor.

In a specific implementation, in the micromirror unit 200
the support frame 221 may be a support frame 221 fabricated by using a silicon material; and/or
the support post 211 may be a support post 211 fabricated by using a silicon material; and/or
the elastic member 224 may be an elastic member 224 fabricated by using a silicon material; and/or
the rotation block 222 may be a rotation block 222 fabricated by using a silicon material.

A silicon material has characteristics of stable chemical properties, a desirable thermal conduction effect, desirable reliability, and a long service life. Therefore, when the support frame 221, the support post 211, the elastic member 224, and the rotation block 222 are fabricated by using a silicon material, the micromirror unit 200 has characteristics of a desirable heat dissipation effect, a long service life, and desirable reliability.

Specifically, the elastic member 224 may be at least one spring. When the elastic member 224 is made of a silicon material, the elastic member 224 is at least one silicon spring. As shown in the structure in FIG. 4, the elastic member 224 is two springs. An end of each piezoelectric drive arm 223 is connected to the rotation block 222 by using the two springs 224.

Further, as shown in a structure in FIG. 2, FIG. 5, and FIG. 6, the plurality of piezoelectric drive arms 223 in the drive apparatus 220 are evenly distributed in a circumferential direction of the rotation block 222.

The plurality of piezoelectric drive arms 223 in the drive apparatus 220 are evenly distributed in the circumferential direction of the rotation block 222. An end of the piezoelectric drive arm 223 is connected to the rotation block 222 by using the elastic member 224. Therefore, the plurality of piezoelectric drive arms 223 in the drive apparatus 220 form a radial radiation shape centered at the rotation block 222. The plurality of evenly distributed piezoelectric drive arms 223 can improve accuracy and stability of movement in the drive apparatus 220.

On a basis of the various micromirror units 200, based on a quantity of the piezoelectric drive arms 223 in the drive apparatus 220, there may be two implementations as follows:
Manner 1: As shown in the structure in FIG. 2 and FIG. 4, the drive apparatus 220 includes a first piezoelectric drive arm 2231, a second piezoelectric drive arm 2232, a third piezoelectric drive arm 2233, and a fourth piezoelectric drive arm 2234 whose extending directions pass through a center of the rotation block 222. The extending direction of the first piezoelectric drive arm 2231 is parallel to the extending direction of the second piezoelectric drive arm 2232. The extending direction of the third piezoelectric drive arm 2233 is parallel to the extending direction of the fourth piezoelectric drive arm 2234. The extending direction of the third piezoelectric drive arm 2233 is perpendicular to the extending direction of the first piezoelectric drive arm 2231.

The drive apparatus 220 includes four piezoelectric drive arms 223 evenly distributed in the circumferential direction of the rotation block 222. An end of each of the four piezoelectric drive arms 223 is connected to the rotation block 222 by using the elastic member 224. When voltages applied to the upper electrodes and the lower electrodes of the first piezoelectric drive arm 2231 and the second piezoelectric drive arm 2232 are controlled, the rotation block 222 can be controlled to rotate toward the first piezoelectric drive arm 2231 or the second piezoelectric drive arm 2232 with an axial line perpendicular to the extending direction of the first piezoelectric drive arm 2231 used as a central line. Similarly, when voltages applied to the upper electrodes and the lower electrodes of the third piezoelectric drive arm 2233 and the fourth piezoelectric drive arm 2234 are controlled, the rotation block 222 can be controlled to rotate toward the third piezoelectric drive arm 2233 or the fourth piezoelectric drive arm 2234 with an axial line perpendicular to the extending direction of the third piezoelectric drive arm 2233 used as a central line. In addition, when voltages applied to the upper electrodes and the lower electrodes of the four piezoelectric drive arms 223 are controlled, the rotation block 222 can further be controlled to rotate in another direction, so as to drive the mirror 210 to rotate to adjust the deflection angle of the mirror 210.

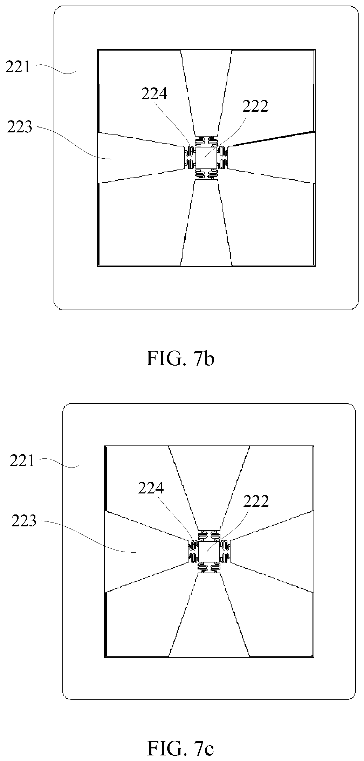

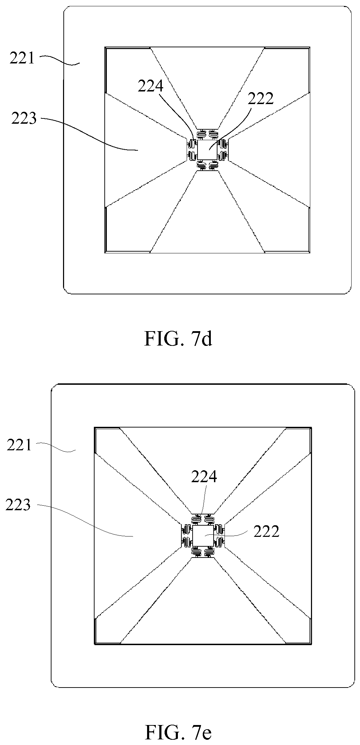

A shape of the piezoelectric drive arm 223 is not limited to a shape mentioned for the drive apparatus 220. The piezoelectric drive arm 223 shown in FIG. 2 is rectangular. To increase an inherent frequency of an overall structure of the drive apparatus 220, the shape of the piezoelectric drive arm 223 in Manner 1 can be changed from a rectangle into a taper. A piezoelectric drive arm 223 in FIG. 7a may be considered as a taper-shaped piezoelectric drive arm whose taper angle is 0°. A taper angle of a piezoelectric drive arm 220 in FIG. 7b is 10°. A taper angle of a piezoelectric drive arm 220 in FIG. 7c is 20°. A taper angle of a piezoelectric drive arm 220 in FIG. 7d is 30°. A taper angle of a piezoelectric drive arm 220 in FIG. 7e is 40°.

Manner 2: As shown in the structure in FIG. 5 and FIG. 6, the drive apparatus 220 includes a fifth piezoelectric drive arm 2235, a sixth piezoelectric drive arm 2236, and a seventh piezoelectric drive arm 2237 whose extending directions pass through a center of the rotation block 222. An included angle between the extending direction of the fifth piezoelectric drive arm 2235 and the extending direction of the sixth piezoelectric drive arm 2236 is 120°. An included angle between the extending direction of the fifth piezoelectric drive arm 2235 and the extending direction of the seventh piezoelectric drive arm 2237 is 120°. An included angle between the extending direction of the sixth piezoelectric drive arm 2236 and the extending direction of the seventh piezoelectric drive arm 2237 is 120°.

The drive apparatus 220 includes three piezoelectric drive arms 223 evenly distributed in the circumferential direction of the rotation block 222. Angles between extending directions of every two adjacent piezoelectric drive arms 223 are 120°. An end of each of the three piezoelectric drive arms 223 is connected to the rotation block 222 by using the elastic member 224. When voltages applied to upper electrodes and lower electrodes of the three piezoelectric drive arms 223 are controlled, the rotation block 222 can be controlled to respectively rotate with three axial lines used as central lines. The three axial lines are respectively axial lines perpendicular to the extending directions of the three piezoelectric drive arms 223, so as to drive the mirror 210 to rotate to adjust the deflection angle of the mirror 210.

In the structure shown in FIG. 2, FIG. 5, and FIG. 6, the mirror 210 in the micromirror unit 200 may be a circular mirror 210 or a square mirror 210. A shape of the mirror 210 is not limited to a circle or a square. A mirror 210 having another shape may alternatively be chosen according to an actual requirement.

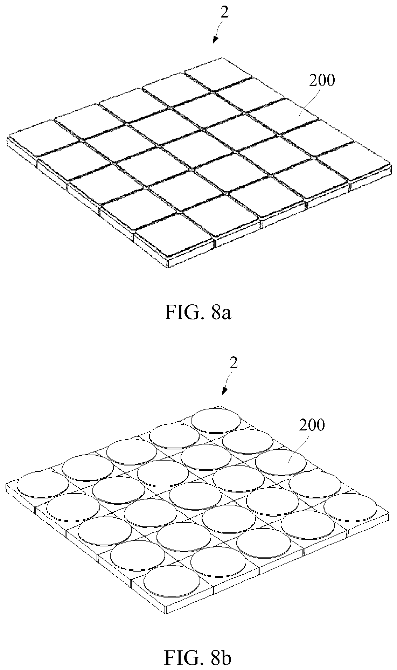

In addition, in a structure shown in FIG. 8a and FIG. 8b, this application further provides a micromirror array 2. The micromirror array 2 includes a plurality of any micromirror units 200 provided in the foregoing embodiment. The plurality of micromirror units 200 are distributed in an array. As shown in FIG. 8a and FIG. 8b, 25 micromirror units 200 distributed in an array are respectively provided. Depending on actual use, the micromirror array 2 may alternatively include any quantity of micromirror units 200 distributed in an array.

When the micromirror array 2 uses the micromirror units 200 for array distribution, because the micromirror unit 200 has a high mirror fill factor, more micromirror units 200 can be integrated in a unit area, so that an integration degree of the micromirror array 2 is increased. When a quantity of the micromirror units 200 is unchanged, a volume of the micromirror array 2 can be reduced.

This application further provides an optical cross-connect module. The optical cross-connect module includes the micromirror array 2 provided in the foregoing embodiment.

When the optical cross-connect module uses the micromirror array 2, if a mirror fill factor of the micromirror unit 200 is high, more micromirror units 200 can be integrated in a unit area, and it facilitates assembly of a multi-port optical cross-connect module by using the micromirror array 2.

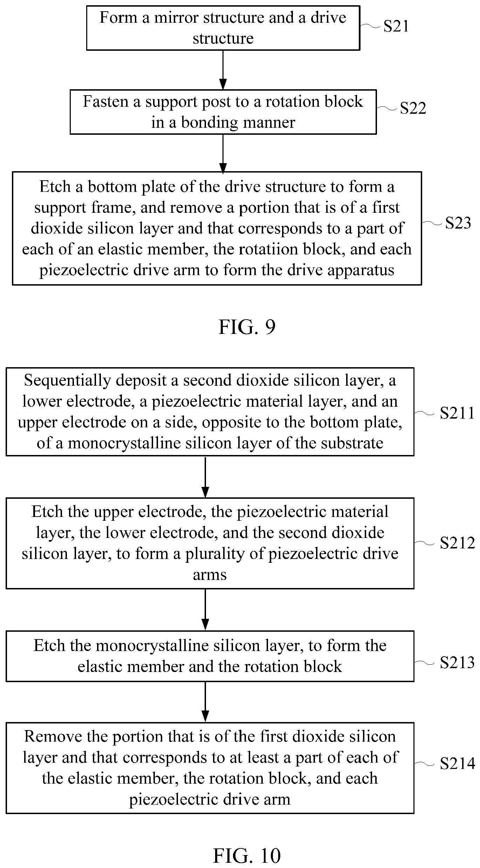

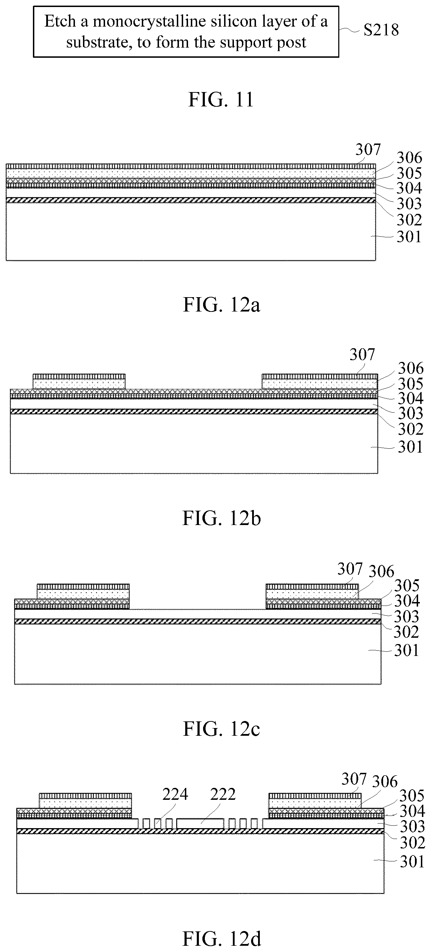

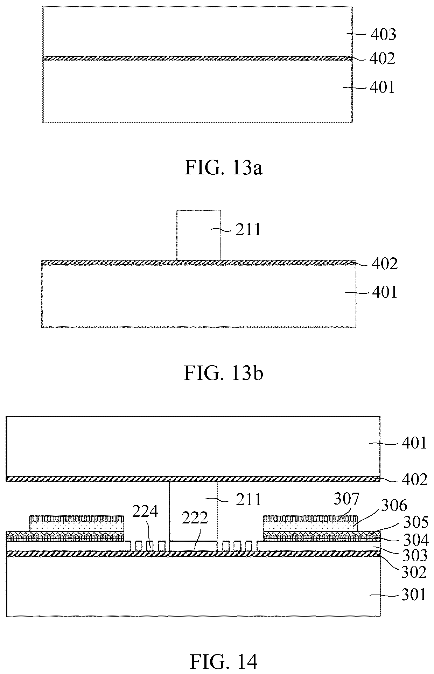

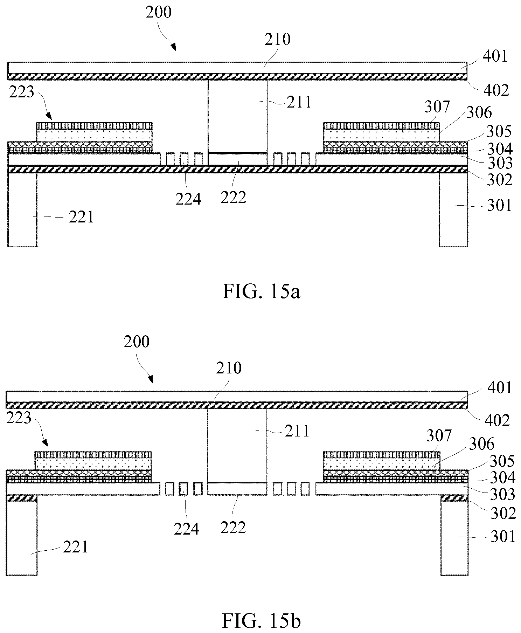

In addition, as shown in FIG. 9, this application further provides a fabrication method of any micromirror unit 200 provided in the foregoing embodiment. The fabrication method specifically includes the following steps:
Step S21: Form a mirror structure and a drive structure. The mirror structure includes a mirror 210 and a support post 211 located on a side of the mirror 210. The drive structure includes a substrate and a plurality of piezoelectric drive arms 223 formed on a side, facing the mirror 210, of the substrate. The substrate includes a bottom plate 301, a first dioxide silicon layer 302, and a monocrystalline silicon layer 303. The monocrystalline silicon layer 303 is configured to form a rotation block 222 and an elastic member 224. The plurality of piezoelectric drive arms 223 are disposed surrounding the rotation block 222. An end of each piezoelectric drive arm 223 is connected to the rotation block 222 by using the elastic member 224. The piezoelectric drive arm 223 includes an upper electrode, a lower electrode, and a piezoelectric material sandwiched between the upper electrode and the lower electrode. During a specific formation process, for corresponding schematic structural diagrams, refer to structures in FIG. 12a to FIG. 12d, FIG. 13a, and FIG. 13b.
Step S22: Fasten the support post 211 to the rotation block 222 in a bonding manner.
Step S23: Etch the bottom plate of the drive structure to form a support frame 221, and remove a portion that is of the first dioxide silicon layer 302 and that corresponds to at least a part of each of the elastic member 224, the rotation block 222, and each piezoelectric drive arm 223 to form a drive apparatus 220. As shown in a structure in FIG. 15a and FIG. 15b, the bottom plate is etched to form the support frame 221, and portions that are of the bottom plate and that correspond to the elastic member 224, the rotation block 222, and each piezoelectric drive arm 223 are removed to form the drive apparatus 220.

In a specific implementation, as shown in FIG. 10, in the forming the drive apparatus 220 in step S21:
before the fastening the support post 211 to the rotation block 222 in a bonding manner, the fabrication method includes the following steps:
Step S211: Sequentially deposit a second dioxide silicon layer 304, a lower electrode 305, a piezoelectric material layer 306, and an upper electrode 307 on a side, opposite to the bottom plate 301, of the monocrystalline silicon layer 303 of the substrate. As shown in the structure in FIG. 12a, the second dioxide silicon layer 304, the lower electrode 305, the piezoelectric material layer 306, and the upper electrode 307 are sequentially formed on the monocrystalline silicon layer 303.
Step S212: Etch the upper electrode 305, the piezoelectric material layer 306, the lower electrode 307, and the second dioxide silicon layer 304, to form the plurality of piezoelectric drive arms 223, as shown in the structure in FIG. 12b and FIG. 12c.
Step S213: Etch the monocrystalline silicon layer 303, to form the elastic member 224 and the rotation block 222, as shown in the structure in FIG. 12d. The monocrystalline silicon layer 303 is etched, so that an end of the piezoelectric drive arm 223 is connected to the rotation block 222 by using the elastic member 224.

After the fastening the support post 211 to the rotation block 222 in a bonding manner, the fabrication method includes the following step:
Step S214: Remove the portion that is of the first dioxide silicon layer 302 and that corresponds to at least a part of each of the elastic member 224, the rotation block 222, and each piezoelectric drive arm 223, to form the drive apparatus 220, as shown in the structure in FIG. 15a and FIG. 15b.

Specifically, as shown in FIG. 11, the step of forming a mirror structure includes the following step:
Step S218: Etch a monocrystalline silicon layer 403 of a substrate, to form the support post 211, as shown in the structure in FIG. 13b. A structure of the substrate is shown by the structure in FIG. 13a. The substrate includes a bottom plate 401, a first dioxide silicon layer 402, and the monocrystalline silicon layer 403.

Further, in the fastening the support post 211 to the rotation block 222 in a bonding manner in step S22, the bonding is low temperature bonding, as shown by the support post 211 and the rotation block 222 fastened in a bonding manner in the structure in FIG. 14.

The support post 211 and the rotation block 222 are bonded at low temperature. Therefore, quality and strength of bonding between the support post 211 and the rotation block 222 can be improved.

The following describes some terms in this application, to help a person skilled in the art have a better understanding.

"Plurality of' means two or more than two.

In addition, it should be understood that in the description of this application, terms such as "first" and "second" are used only for distinguishing in the description, but are not intended to indicate or imply relative importance or an order.

A person skilled in the art should understand that the embodiments of this application may be provided as a method, a system, or a computer program product. Therefore, this application may use a form of hardware only embodiments, software only embodiments, or embodiments with a combination of software and hardware. Moreover, this application may use a form of a computer program product that is implemented on one or more computer-usable storage media (including but not limited to a disk memory, a CD-ROM, an optical memory, and the like) that include computer usable program code.

This application is described with reference to the flowcharts and/or block diagrams of the method, the device (system), and the computer program product according to the embodiments of this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specified function in one or more processes in the flowcharts and/or in one or more blocks in the block diagrams.

These computer program instructions may be stored in a computer readable memory that can instruct the computer or any other programmable data processing device to work in a specific manner, so that the instructions stored in the computer readable memory generate an artifact that includes an instruction apparatus. The instruction apparatus implements a specified function in one or more processes in the flowcharts and/or in one or more blocks in the block diagrams.

These computer program instructions may be loaded onto a computer or another programmable data processing device, so that a series of operations and steps are performed on the computer or the another programmable device, thereby generating computer-implemented processing. Therefore, the instructions executed on the computer or the another programmable device provide steps for implementing a specified function in one or more processes in the flowcharts and/or in one or more blocks in the block diagrams.

Obviously, a person skilled in the art can make various modifications and variations to the embodiments of this application without departing from the spirit and scope of the embodiments of the present invention. This application is intended to cover these modifications and variations provided that they fall within the scope of protection defined by the following claims and their equivalent technologies.

## Claims

1. A micromirror unit, comprising a mirror and a drive apparatus, wherein a support post is disposed on a side, facing the drive apparatus, of the mirror; the drive apparatus comprises a support frame, a rotation block fastened to the support post, and a plurality of piezoelectric drive arms disposed surrounding the rotation block; and an end of each piezoelectric drive arm is fastened to the support frame, the other end is connected to the rotation block by using an elastic member, and the piezoelectric drive arm comprises an upper electrode, a lower electrode, and a piezoelectric material sandwiched between the upper electrode and the lower electrode.

2. The micromirror unit according to claim 1, wherein the support frame is a support frame fabricated by using a silicon material; and/or
the support post is a support post fabricated by using a silicon material; and/or
the elastic member is an elastic member fabricated by using a silicon material; and/or
the rotation block is a rotation block fabricated by using a silicon material.

3. The micromirror unit according to claim 1, wherein the elastic member is at least one spring.

4. The micromirror unit according to claim 1, wherein the plurality of piezoelectric drive arms in the drive apparatus are evenly distributed in a circumferential direction of the rotation block.

5. The micromirror unit according to claim 4, wherein the drive apparatus comprises a first piezoelectric drive arm, a second piezoelectric drive arm, a third piezoelectric drive arm, and a fourth piezoelectric drive arm whose extending directions pass through a center of the rotation block, wherein the extending direction of the first piezoelectric drive arm is parallel to the extending direction of the second piezoelectric drive arm, the extending direction of the third piezoelectric drive arm is parallel to the extending direction of the fourth piezoelectric drive arm, and the extending direction of the third piezoelectric drive arm is perpendicular to the extending direction of the first piezoelectric drive arm.

6. The micromirror unit according to claim 4, wherein the drive apparatus comprises a fifth piezoelectric drive arm, a sixth piezoelectric drive arm, and a seventh piezoelectric drive arm whose extending directions pass through a center of the rotation block, wherein an included angle between the extending direction of the fifth piezoelectric drive arm and the extending direction of the sixth piezoelectric drive arm is 120°, an included angle between the extending direction of the fifth piezoelectric drive arm and the extending direction of the seventh piezoelectric drive arm is 120°, and an included angle between the extending direction of the sixth piezoelectric drive arm and the extending direction of the seventh piezoelectric drive arm is 120°.

7. The micromirror unit according to any one of claims 1 to 6, wherein the mirror is a circular mirror, or the mirror is a square mirror.

8. A micromirror array, comprising a plurality of the micromirror units according to any one of claims 1 to 7, wherein the plurality of the micromirror units are distributed in an array.

9. An optical cross-connect module, comprising the micromirror array according to claim 8.

10. A fabrication method of the micromirror unit according to any one of claims 1 to 7, comprising:
forming a mirror structure and a drive structure, wherein the mirror structure comprises a mirror and a support post located on a side of the mirror; the drive structure comprises a substrate and a plurality of piezoelectric drive arms formed on a side, facing the mirror, of the substrate; the substrate comprises a bottom plate, a first dioxide silicon layer, and a monocrystalline silicon layer, and the monocrystalline silicon layer is configured to form a rotation block and an elastic member; and the plurality of piezoelectric drive arms are disposed surrounding the rotation block, an end of each piezoelectric drive arm is connected to the rotation block by using the elastic member, and the piezoelectric drive arm comprises an upper electrode, a lower electrode, and a piezoelectric material sandwiched between the upper electrode and the lower electrode;
fastening the support post to the rotation block in a bonding manner; and
etching the bottom plate of the drive structure to form a support frame, and removing a portion that is of the first dioxide silicon layer and that corresponds to at least a part of each of the elastic member, the rotation block, and each piezoelectric drive arm to form a drive apparatus.

11. The fabrication method according to claim 10, wherein in the step of forming the drive apparatus:
before the fastening the support post to the rotation block in a bonding manner, the fabrication method comprises:
sequentially depositing a second dioxide silicon layer, the lower electrode, a piezoelectric material layer, and the upper electrode on a side, opposite to the bottom plate, of the monocrystalline silicon layer of the substrate;
etching the upper electrode, the piezoelectric material layer, the lower electrode, and the second dioxide silicon layer, to form the plurality of piezoelectric drive arms; and
etching the monocrystalline silicon layer, to form the elastic member and the rotation block; and
after the fastening the support post to the rotation block in a bonding manner, the fabrication method comprises:
removing the portion that is of the first dioxide silicon layer and that corresponds to at least a part of each of the elastic member, the rotation block, and each piezoelectric drive arm.

12. The fabrication method according to claim 10, wherein the step of forming a mirror structure comprises:
etching a monocrystalline silicon layer of a substrate, to form the support post.

13. The fabrication method according to any one of claims 10 to 12, wherein in the fastening the support post to the rotation block in a bonding manner, the bonding is low temperature bonding.
